# Europäisches Patentamt

(19) **European Patent Office**

**Office européen des brevets**

(11) Numéro de publication : **0 215 031**
**B1**

(12) **FASCICULE DE BREVET EUROPÉEN**

(45) Date de publication du fascicule du brevet :
26.04.89

(51) Int. Cl.⁴ : **C 23 C   2/00**

(21) Numéro de dépôt : **86901320.1**

(22) Date de dépôt : **25.02.86**

(86) Numéro de dépôt international :
**PCT/CH 86/00026**

(87) Numéro de publication internationale :
**WO/8605213 (12.09.86 Gazette 86/20)**

(54) PROCEDE POUR FORMER SELECTIVEMENT AU MOINS UNE BANDE DE REVETEMENT D'UN METAL OU ALLIAGE SUR UN SUBSTRAT D'UN AUTRE METAL.

(30) Priorité : **04.03.85 CH 963/85**

(43) Date de publication de la demande :
**25.03.87 Bulletin 87/13**

(45) Mention de la délivrance du brevet :
**26.04.89 Bulletin 89/17**

(84) Etats contractants désignés :
**AT BE CH DE FR GB IT LI LU NL SE**

(56) Documents cités :
**EP–A– 0 023 472**
**DE–A– 2 134 444**
**FR–A–   860 375**
**FR–A–   923 246**
**FR–A– 1 153 715**
**FR–A– 1 584 626**
**US–A– 2 959 829**
**US–A– 3 201 275**

(73) Titulaire : **BATTELLE MEMORIAL INSTITUTE**
**7 route de Drize**
**CH-1227 Carouge/Genève (CH)**

(72) Inventeur : **HAOUR, Georges**
**5, rue Saint-Ours**
**CH-1205 Genève (CH)**
Inventeur : **RICHTER, Dag, Fredrik**
**6 bis, rue des Moraines**
**CH-1227 Carouge (CH)**
Inventeur : **BOSWELL, Peter**
**Ch. Fief-de-Chapitre 5**
**CH-1213 Petit-Lancy (CH)**
Inventeur : **WAGNIERES, Willy**
**14, chemin d'Ami**
**CH-1212 Grand-Lancy (CH)**

(74) Mandataire : **Dousse, Blasco et al**
**7, route de Drize**
**CH-1227 Carouge/Genève (CH)**

## Description

La présente invention se rapporte à un procédé pour former sélectivement au moins une bande de revêtement d'un métal ou alliage sur un substrat d'un autre métal.

Il existe des quantités de procédés pour revêtir un substrat métallique d'un autre métal. On peut citer notamment les dépôts électrolytiques, les dépôts par CVD (dépôts chimiques de vapeur) ou par PVD (dépôts physiques de vapeur), des procédés de co-laminage à chaud et enfin des procédés de revêtement avec du métal en fusion, soit en trempant le substrat dans un bain de métal liquide comme dans le cas du zingage, soit en déposant le métal liquide sur le substrat.

Les procédés électrolytiques, CVD et PVD sont chers en raison de leur lenteur, le co-laminage est une opération délicate lorsque l'on désire obtenir des couches de l'ordre de 10 à 40 μm notamment. De leur côté, les procédés de revêtement par du métal ou un alliage en fusion présentent l'inconvénient de rendre difficile la maîtrise de la structure du revêtement. En effet, lorsque l'on revêt un substrat chaud par du métal en fusion, il est nécessaire qu'il y ait un bon mouillage du métal du substrat par le métal de revêtement en fusion. Ce mouillage est fonction du temps de contact et de la température à laquelle ce contact se produit. Pendant ce processus de mouillage, une diffusion du métal du substrat dans celui de revêtement se produit. Ce processus de diffusion est interrompu par la formation d'un composé intermétallique entre le substrat et le métal de revêtement et par la solidification du revêtement. Dans certaines applications, notamment des applications électriques où la résistivité du revêtement constitue un facteur primordial, la présence d'alliage formé par dissolution du métal du substrat n'est pas acceptable, la majeure partie du revêtement devant être constituée de métal ou d'alliage dont la pureté est de préférence supérieure à 99 %. Compte tenu de la dissolution plus ou moins importante du métal du substrat dans le métal ou l'alliage de revêtement, inhérente au mouillage de ce substrat, qui est le gage d'une bonne adhérence du revêtement, les nombreux procédés de dépôts à l'aide de métal ou d'alliage fondu n'ont pas pu être utilisés pour nombre d'applications électriques ou électroniques notamment, par exemple pour des supports de connexion de circuits intégrés ou pour des éléments de contacts électriques. Or, l'utilisation de tels procédés permettrait d'accroître de façon notable la productivité des opérations de revêtement de tels substrats.

On a déjà proposé dans le FR-A-1 584 626 d'enrober un ruban d'acier d'une couche d'aluminium ou d'alliage d'aluminium en faisant passer verticalement ce ruban de bas en haut à travers une fente verticale d'un bec d'alimentation relié à un creuset d'aluminium en fusion. En passant dans l'aluminium liquide remplissant la fente verticale, le ruban se déplaçant de bas en haut crée des forces capillaires qui équilibrent la force de gravité s'exerçant sur le liquide et est recouvert de métal à la sortie de cette fente. Après solidification on obtient un ruban d'acier enrobé d'aluminium. Il s'agit donc d'un procédé d'enrobage qui permet d'obtenir des couches de 20 à 100 μm d'épaisseur avec formation à l'interface d'une couche de composé intermétallique ne dépassant pas 2 μm.

Un tel procédé ne permet pas de réaliser des revêtements sélectifs sous forme de bandes sur un substrat, mais uniquement de l'enrober. Il ne permet pas de réaliser des revêtements dont l'épaisseur descend jusqu'à 4 μm. Or, il existe de nombreuses applications, notamment en électronique, dans lesquelles il est nécessaire de réaliser des revêtements sous forme de bandes, dont l'épaisseur est inférieure à 10 μm. Lorsqu'on réduit l'épaisseur du revêtement, on réduit en proportion le débit de métal. De ce fait, avec le procédé décrit dans le document cité ci-dessus, dans lequel le métal liquide est maintenu en équilibre par les forces capillaires du ruban qui se déplace de bas en haut, si le débit de métal diminue, le temps de séjour du métal fondu dans le bec augmente, d'où le risque que ce métal en fusion se trouve peu à peu contaminé par le métal du substrat dont la dissolution, compte tenu du volume de métal liquide stagnant dans le bec, peut se propager dans cette masse de métal au fur et à mesure du déroulement du procédé. De ce fait, même s'il est possible de limiter l'épaisseur de la couche intermétallique à moins de 2 μm, il est probable que la pureté du reste du métal de revêtement soit abaissée de façon significative, c'est-à-dire au-delà de 2 % à 3 % par rapport à sa pureté initiale, ce qui exclut certaines applications notamment dans le domaine de l'électronique.

Cette probabilité est d'autant plus grande que, contrairement à l'application unique décrite dans le FR-A-1 585 626 où il s'agit de déposer une couche d'Al ou d'alliage Al que sur un substrat en acier inoxydable ou martensitique, dans les applications destinées à l'électronique, le revêtement est en Al ou un alliage Pb — Sn notamment sur un substrat de Cu/Sn, Fe, Cu, Fe/Ni etc. Or, il s'avère que les vitesses de dissolution des métaux des substrats utilisés pour ces applications sont toutes plus rapides que celles de l'acier inoxydable ou martensitique.

On comprend dès lors que, quand bien même les techniques de revêtement d'un métal sur un substrat d'un autre métal existent depuis plus de 50 ans et qu'elles ont fait l'objet de nombreuses applications dont la littérature fait foi, le revêtement de substrat par des bandes métalliques très minces, notamment < 20 μm voire < 10 μm avec du métal dont la pureté est de l'ordre de 99 % sur les 4/5 de son épaisseur n'a encore pas pu être réalisé par cette technique qui n'était réservée jusqu'ici qu'à des technologies dont les exigences étaient moins contraignantes.

Le but de la présente invention est une adaptation de la technologie des revêtements en bandes par dépôt de métal liquide sur des substrats, susceptibles de satisfaire les normes de pureté les plus sévères, qui ne sont réalisables actuellement que par les techniques de dépôts susmentionnées dont la productivité est très sensiblement inférieure à celle de la technique par dépôt de métal liquide.

A cet effet, la présente invention a pour objet un procédé pour former sélectivement au moins une bande de revêtement d'un métal ou alliage de 4 à 50 μm d'épaisseur sur un substrat d'un autre métal dont le point de fusion est supérieur à celui du revêtement selon la revendication 1.

Les avantages de ce procédé découlent bien évidemment de sa productivité accrue par rapport aux procédés de l'état de la technique. Comme on le constatera des exemples cités ci-après, ce procédé permet un parfait contrôle de la nature de la couche déposée quel que soit le métal du substrat et le métal ou l'alliage qui y est déposé. Les bandes métalliques ainsi déposées présentent toutes, au-dessus de la couche intermétallique d'épaisseur limitée, le métal ou l'alliage avec une pureté sensiblement égale à celle de l'alliage ou du métal initial. En outre, la section de la bande de métal déposée est rectangulaire et donc constante et sa largeur est régulière.

L'avantage de cette invention est de permettre la production de substrats métalliques revêtus de métal ou d'alliage en fusion, sans que la diffusion du métal du substrat dans le revêtement n'affecte, avec une concentration inadmissible, une portion de l'épaisseur du revêtement telle que les propriétés physiques propres au métal ou à l'alliage choisi soient affectées, dans une proportion susceptible de le rendre, par exemple, impropre à des utilisations spécifiques qui requièrent précisément ces propriétés. C'est ainsi que l'on peut réaliser sur des substrats conducteurs, des pistes destinées à la connexion de circuits intégrés qui ont une épaisseur de l'ordre de 10 μm et dont la majeure partie doit être constituée par le métal de revêtement, avec une pureté supérieure à 98 %.

Le dessin annexé illustre schématiquement et à titre d'exemple les parties essentielles d'une installation de production du substrat métallique objet de l'invention et des diagrammes relatifs aux paramètres de fonctionnement de cette installation.

La fig. 1 est une vue générale en élévation de l'installation de revêtement.

La fig. 2 est une vue partielle en élévation latérale très schématique et agrandie de la fig. 1 représentant les paramètres qui sont en relation avec la mise en œuvre du procédé.

Les fig. 3 et 4 sont des diagrammes relatifs à différents paramètres de fonctionnement.

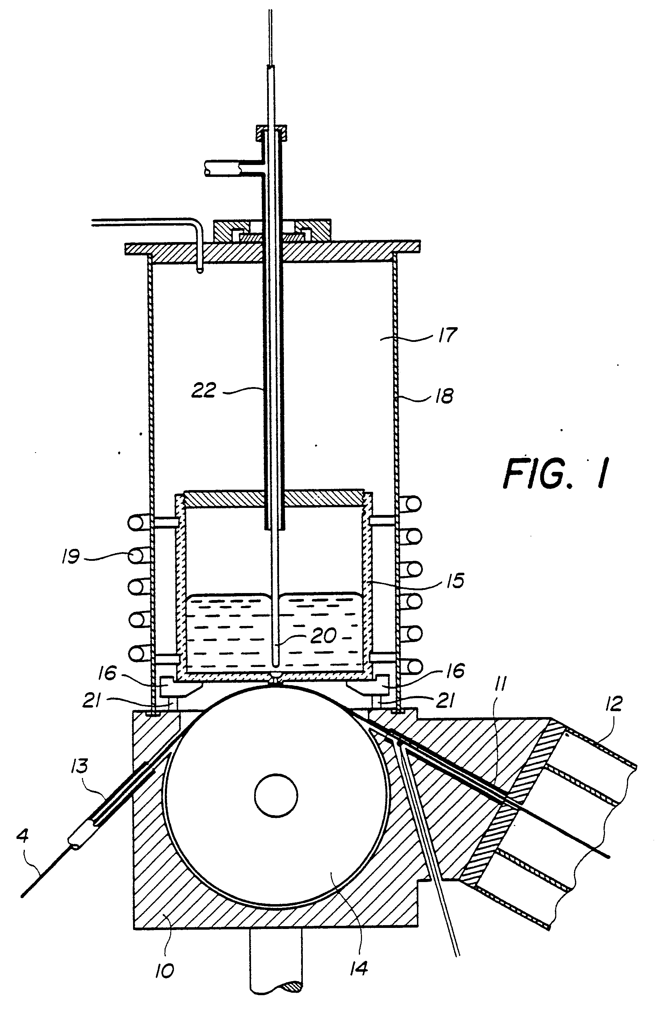

L'installation proprement dite telle qu'elle est illustrée par la fig. 1 comporte un bâti 10 comprenant un canal d'entrée 11 du ruban à revêtir à la sortie d'une enceinte de préchauffage 12, un canal de sortie 13 associé à un circuit de refroidissement à l'eau froide (non représenté) un cylindre de graphite 14 monté rotativement sur le bâti et refroidi à l'eau par un circuit (non représenté). Un creuset 15 repose sur un anneau de support 16 en céramique positionné par des vis de réglage 21. Ce creuset est logé dans une enceinte fermée 17 dont la paroi latérale est constituée par un tube de quartz 18 et est chauffée par induction haute fréquence par une bobine 19 disposée autour du tube de quartz 18. L'enceinte 17 est alimentée en gaz neutre type $N_2$ — 10 % $H_2$. Un thermocouple 20 est placé dans le creuset 15 pour mesurer la température du métal et passe à travers un tube 22 destiné à être relié à la source de gaz neutre pour créer une pression dynamique dans le creuset destinée à s'ajouter à la pression statique résultant de la hauteur de métal liquide.

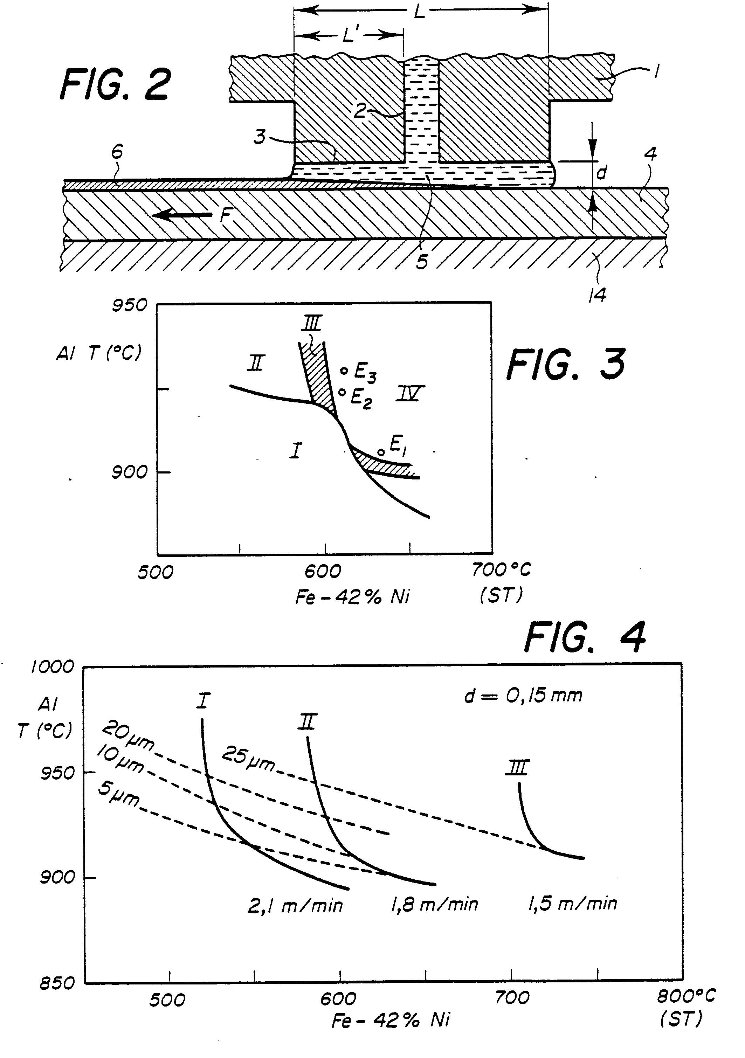

La figure 2 montre une buse 1 comprenant un conduit d'alimentation en métal liquide 2 provenant du creuset 15 (fig. 4). Cette buse se termine par des lèvres 3 qui font saillie sous la face inférieure du creuset de part et d'autre du conduit d'alimentation 2 parallèlement à la direction de déplacement du substrat à revêtir 4. Le métal liquide 5 sortant du conduit d'alimentation 2 de la buse 1 se répartit par capillarité entre le substrat 4 et les lèvres 3 de la buse 1. Au fur et à mesure que le substrat se déplace dans le sens de la flèche F, une portion du métal liquide se solidifie au contact de ce substrat et est entraînée avec lui pour former le revêtement 6.

La première condition qui doit être réalisée est la parfaite adhérence du revêtement 6 sur le substrat 4. A cet effet, le substrat doit être chauffé à une température inférieure à sa température de fusion qui est elle-même supérieure à celle du métal destiné à former le revêtement 6. Cette adhérence est subordonnée à un parfait mouillage du substrat qui ne peut être garanti que si le temps de contact entre ce substrat et le métal en fusion est suffisant avant que ne commence la solidification du revêtement 6. Pendant cette phase de mouillage du substrat 4 par le métal liquide 5, le métal du substrat 4 diffuse dans le métal de revêtement et forme avec lui des composés intermétalliques qui altèrent les propriétés physiques du métal de revêtement. Généralement, avec ce mode de revêtement, la diffusion du métal du substrat est tellement importante que le ou les composés intermétalliques affectent la majeure partie de l'épaisseur du revêtement, le reste de ce revêtement comportant sous forme d'alliage, le métal du substrat, de sorte que le métal du revêtement ne se retrouve pas à l'état pratiquement pur dans le revêtement ou au moins à l'état suffisamment pur pour plusieurs applications auquel il est destiné.

Pour remédier à cet inconvénient, sans nuire à l'adhérence du revêtement sur le substrat, il est nécessaire de réunir un ensemble de conditions qui, une fois le mouillage du substrat 4 assuré, assurent une vitesse de solidification du revêtement qui soit aussi rapide que possible et plus rapide que la vitesse de diffusion du métal du substrat dans le métal liquide déposé à sa surface, pour bloquer cette diffusion aussi près que possible du substrat et assurer qu'une proportion aussi grande que possible du revêtement 6 soit fermée de métal aussi pur que possible et que la couche de composé intermétallique soit aussi mince que possible. Il est évident que les paramètres entrant en jeu sont nombreux. Ils sont liés, d'une part, à des dimensions constructives de l'installation, d'autre part, à des conditions opératoires et enfin à la vitesse de diffusion du métal du substrat dans le métal de revêtement, ainsi qu'au diagramme de phase relatif aux métaux utilisés. C'est la raison pour laquelle, si le processus conduisant à la formation d'un revêtement formé en grande partie de métal aussi pur que possible (ou d'un alliage déterminé) est explicable par la théorie exposée ci-dessus relative aux vitesses de dissolution et de solidification, on comprendra aisément qu'il est difficile de fixer une règle commune, celle-ci étant non seulement tributaire des conditions opératoires, mais également des propriétés que les différents métaux en présence ont de former un ou plusieurs composés intermétalliques, à différentes températures au cours du refroidissement du revêtement. Dans certains cas, les métaux en présence ont de ce fait une tendance plus ou moins marquée à former un ou plusieurs composés intermétalliques, qui se traduit par une couche d'épaisseur plus ou moins grande de ce ou ces composés dans le revêtement. On a cependant pu établir, par une série d'essais réalisés avec différents métaux ou alliages, utilisés pour former des revêtements sur des substrats formés d'autres métaux ou alliages à points de fusion plus élevés que ceux des métaux ou alliages déposés, qu'il est possible d'obtenir des revêtements de 5 à 50 μm d'épaisseur ne comprenant pas une couche de composé intermétallique supérieure à 0,5 à 4 μm, dans une limite ne dépassant pas 40 % de l'épaisseur totale du revêtement et que le métal ou l'alliage de revêtement initial se retrouve avec une teneur d'au moins 97 % dans le reste de ce revêtement. On verra dans les exemples qui vont suivre que, dans bien des cas, les limites susmentionnées peuvent être notablement réduites et que l'on peut obtenir des revêtements pour des technologies aussi exigentes que les supports de connexion de circuits intégrés par exemple, où le degré de pureté requis du métal de revêtement et l'épaisseur de la couche intermétallique doivent répondre à des exigences très sévères.

Tous les exemples cités ont été réalisés avec la même installation, les lèvres 3 de la buse 1 présentant une longueur totale L de 2,7 mm, le conduit d'alimentation 2 de la buse présentant une section circulaire ou rectangulaire suivant la largeur du revêtement désiré. La distance d'entre les lèvres 3 de la buse 1 et le substrat 4 présente une assez grande importance. Elle ne peut en aucun cas excéder 0,5 mm et se situe généralement à 0,15 mm, voire moins, quelle que soit l'épaisseur du revêtement. La longueur L des lèvres 3 situées de part et d'autre du conduit 2 doit avoir une dimension minimum de l'ordre de 2 mm, la dimension L' quant à elle doit être comprise entre 0,5-5 mm. Le conduit 2 peut être décentré vers l'arrière de la buse 1 et par rapport au sens de défilement F du substrat 4. Il faut signaler que, dans le cas particulier, l'installation travaille avec une buse à axe vertical, la surface du substrat sur laquelle a lieu le dépôt est horizontale. Toutefois, si cette position facilite la mise en œuvre, il n'est pas exclu que l'axe de la buse soit horizontal et que le substrat soit vertical et se déplace de bas en haut étant donné que le métal liquide forme un ménisque entre le substrat et les lèvres 3 de la buse sous l'effet de forces capillaires.

Comme illustré par la fig. 1, le ruban-substrat 4, préalablement chauffé, passe sur le cylindre 14 qui tourne à la vitesse du ruban. Ce dernier commence à se refroidir à partir de son revers au moment où sur l'avers, le métal fondu est déposé. Par conséquent, le refroidissement du métal liquide commence par l'interface avec le substrat, réduisant ainsi le temps pendant lequel le métal du substrat peut se dissoudre dans le métal liquide. Dans le cas d'un substrat mince, cette particularité est importante, étant donné, d'une part, que l'écartement entre le ruban 4 et la buse 1 doit être maintenu constant et, d'autre part, que l'inertie thermique du ruban étant très faible compte tenu de son épaisseur, il est important de refroidir le ruban. Or, comme il faut le supporter pour l'empêcher de vibrer, le refroidissement le plus rapide ne peut être obtenu que par l'intermédiaire du support lui-même, d'où l'intérêt d'utiliser un support rotatif dont la surface de refroidissement change constamment et a le temps de se refroidir elle-même avant de revenir en contact avec une autre portion du ruban. La forme cylindrique du support est importante, dans la mesure où elle permet d'exercer une tension sur le ruban 4 assurant un bon contact avec le support, empêchant à la fois le ruban de vibrer et garantissant un bon transfert thermique entre le ruban et le cylindre de support 14.

En quittant la surface du cylindre 14, le ruban rentre dans le canal de refroidissement dans lequel un brouillard de liquide est pulvérisé pour finir de le refroidir.

Exemple 1

Cet exemple est relatif au dépôt d'une piste d'aluminium 99,99 % sur un sustrat constitué par un ruban de Fe — 42 % Ni.

Les conditions opératoires du procédé de dépôt sont les suivantes : le substrat 4 est préchauffé à 620 °C, l'aluminium est fondu à une température de 910 °C. La buse 1 est en graphite et le conduit d'alimentation 2 a une section rectangulaire de 0,7×5,0 mm, le grand axe de cette section étant dans un plan perpendiculaire au dessin. On applique sur le métal liquide une pression de 200 mm de colonne d'eau. Avant le revêtement, la surface du substrat est dégraissée dans une solution alcaline et ensuite elle est décapée à l'acide. Le revêtement est réalisé dans une atmosphère de $N_2$ — 10 % $H_2$ et le refroidissement du substrat revêtu est réalisé dans de l'eau. La vitesse de défilement du substrat est de 1,8 m/min.

Les caractéristiques du produit obtenu sont les suivantes : l'épaisseur maximum du revêtement est de 12 $\mu$m et l'épaisseur moyenne est de 8 $\mu$m, la rugosité entre les creux et les bosses est de 0,05 $\mu$m. La couche de composé intermétallique à l'interface est une couche de $(NiFe)Al_3$ de 0,9 $\mu$m d'épaisseur, la dureté du revêtement est de 52 Vickers, la composition de la couche d'aluminium comporte 1 % en poids de (Ni + Fe), on ne constate aucun changement de couleur et l'adhérence du revêtement est bonne.

## Exemple 2

On a de nouveau un substrat de Fe — 42 % Ni recouvert d'une piste de 99,99 % Al. Le substrat est préchauffé à 520 °C et l'aluminium est fondu à 945 °C. Le substrat 4 est déplacé sous la buse 1 à une vitesse de 2,1 m/min, l'écartement entre les lèvres 3 et le substrat 4 est toujours de 0,15 mm. La pression appliquée sur le métal liquide est de 300 mm de colonne d'eau. La buse est la même que dans l'exemple 1, soit un orifice de 0,7×5,0 mm. La préparation de la bande (substrat) est la même que pour l'exemple 1 et l'atmosphère de revêtement est également du $N_2$ + 10 % $H_2$.

Le revêtement obtenu a une épaisseur maximum de 13 $\mu$m et une épaisseur moyenne de 11 $\mu$m. La rugosité du revêtement entre les creux et les bosses est de 0,02 $\mu$m. La couche de composé intermétallique $(NiFe)Al_3$ à l'interface est de 1,3 $\mu$m, la teneur en Al du revêtement au-dessus de cette couche de composé intermétallique est > 98,5 % en poids, la dureté est de 54 Vickers et l'adhérence est bonne.

## Exemple 3

On réalise un dépôt de 99,99 % Al sur Fe — 42 % Ni dans des conditions voisines de celles de l'exemple 2 et on obtient une épaisseur moyenne de 23 $\mu$m avec une couche de composé intermétallique de 1,6 $\mu$m et une concentration de Al dans le revêtement de 98 % en poids.

Le diagramme de la fig. 3 a été établi en portant en abscisse la température du substrat (ST) et en ordonnée la température de l'aluminium déposé (AlT). Les constantes étaient la vitesse du substrat de 1,8 m/min, le substrat de Fe — 42 % Ni, le 99,99 % Al servant de métal de revêtement du substrat, l'écartement de 0,15 mm entre le substrat et les lèvres 3 de la buse 1 et la largeur de 5,0 mm de la piste d'aluminium déposée.

Ce diagramme montre la présence de quatre zones, une zone 1 dans laquelle le mouillage du substrat est incomplet, une zone II dans laquelle on trouve des particules de composés intermétalliques dans toute l'épaisseur du revêtement, une zone III qui constitue une zone de transition et une zone IV dans laquelle on trouve trois points $E_1$, $E_2$, $E_3$ correspondant respectivement aux exemples 1, 2 et 3 susmentionnés.

Le diagramme de la fig. 4 montre dans un système de coordonnées X, Y donnant respectivement les températures du substrat (ST) et de l'aluminium (AlT), les limites de fonctionnement qui se situent à droite des courbes I, II, III pour des vitesses de substrat de 2,1 m/min, 1,8 m/min et 1,5 m/min respectivement. Les courbes en traits interrompus montrent les épaisseurs minimum (5 $\mu$m, 10 $\mu$m, 20 $\mu$m et 25 $\mu$m) que l'on peut obtenir à ces différentes vitesses, ceci toujours dans le cas de dépôts de 99,99 % Al.

## Exemple 4

On dépose du 99,99 % Al sur un substrat de 99,95 % Cu, en chauffant le substrat à 425 °C et en fondant l'Al à 795 °C. La vitesse de défilement du substrat est de 6,0 m/min, l'écartement entre le substrat et la buse est de 0,15 mm, la pression appliquée sur le métal liquide est de 400 mm de colonne d'eau, la pression métallostatique étant de 20 mm. Le canal 2 de la buse est cylindrique et son diamètre est de 1,05 mm.

Le substrat est préalablement dégraissé au solvant, le revêtement s'effectue sous atmosphère d'argon et le refroidissement est à l'air avec une vitesse de 5 °C/s.

Le revêtement obtenu a une épaisseur de 15 $\mu$m, une durétée de 54 Vickers. La couche de composé intermétallique à la surface du substrat est de 2.0 $\mu$m, le reste du revêtement présentant > 97 % Al.

## Exemple 5

Dépôt de 99,5 % Al sur un substrat de 99,95 % Cu, en chauffant ce dernier à 440 °C et en fondant l'Al à 820 °C. La vitesse de défilement du substrat est de 4,8 m/min. L'écartement entre le substrat et la buse est de 0,4 mm. La pression appliquée sur le métal en fusion est de 700 mm de colonne d'eau, alors que la pression métallostatique est de 25 mm. Le canal de la buse a une section circulaire de 1,2 mm de diamètre.

Le substrat n'est soumis à aucun traitement préalable au revêtement qui se déroule sous atmosphère de 10 % $H_2$ — $N_2$ suivi d'un refroidissement à l'air avec une vitesse de 50 °C/s.

Le revêtement obtenu a une épaisseur de 12 $\mu$m, une dureté de 56 Vickers. L'épaisseur de la couche de composé intermétallique est de 4 $\mu$m, le reste du revêtement présentant > 98.5 % Al.

## Exemple 6

On dépose du Pb — 5 % Sn sur un substrat de Cu — 4 % Sn en chauffant ce dernier à 276 °C et l'alliage de Pb — 5 % Sn à 425 °C. La vitesse de défilement du substrat est de 4,7 m/min et l'écartement entre la buse et le substrat est de 0,08 mm. La pression exercée sur le métal liquide est de 200 mm de colonne d'eau. Le canal d'alimentation de la buse est de section rectangulaire 0,7×12,0 mm.

Le substrat en bande est préalablement dégraissé par une solution alcaline et légèrement décapé à l'acide. Le revêtement se déroule sous atmosphère de 10 % $H_2$ — $N_2$ avec refroidissement dans l'eau.

Le revêtement a une épaisseur maximum de 22 $\mu$m et moyenne de 20 $\mu$m, une dureté de 40 Vickers et une rugosité de 0,05 $\mu$m. La couche de composé intermétallique de ($Cu_6Sn_5$) à la surface du substrat a une épaisseur de 2,0 $\mu$m, le reste de la couche présentant < 1 % Cu. La couleur du revêtement ne change pas.

Exemple 7

On dépose du Pb — 5 % Sn sur un substrat de Cu — 4 % Sn en chauffant ce dernier à 330 °C et en fondant l'alliage de revêtement à 438 °C. La vitesse de défilement du substrat et de 2,1 m/min et l'écartement entre la buse et le substrat est de 0,35 mm. La pression exercée sur le métal en fusion et de 180 mm de colonne d'eau. Le canal d'alimentation de la buse en graphite est de section circulaire de 1,2 mm de diamètre.

Le substrat en bande est préalablement dégraissé dans une solution alcaline. Le revêtement se déroule sous atmosphère de 10 % $H_2$ — $N_2$ et refroidi ensuite dans l'eau.

Le revêtement obtenu a une épaisseur maximum de 44 $\mu$m et moyenne de 22 $\mu$m, sa dureté est de 40 Vickers et sa rugosité de 0,02 $\mu$m. La couche de composé intermétallique ($Cu_6Sn_5$) à la surface du substrat a une épaisseur de 2,5 $\mu$m, le reste de la couche présentant < 1 % Cu. L'adhérence est bonne.

Exemple 8

On dépose du 95 % Pb 5 % Sn sur un substrat de Cu — 4 % Sn en chauffant ce dernier à 290 °C alors que l'alliage déposé est chauffé à 425 °C. La vitesse du substrat est de 7,8 m/min et l'écartement entre la buse et le substrat est de 0,45 mm. La pression exercée sur le métal liquide est de 200 mm de colonne d'eau. Le canal de la buse en graphite a une section rectangulaire de 0,7×5,0 mm.

Le substrat en bande est préalablement dégraissé avec une solution alcaline et ensuite décapé à l'acide. Le revêtement se déroule sous atmosphère de 10 % $H_2$ — $N_2$ et est ensuite refroidi à l'eau.

Le revêtement obtenu a une épaisseur maximum de 38 $\mu$m et moyenne de 33 $\mu$m, sa dureté est de 50 Vickers et sa rugosité de 0,1 $\mu$m. La couche de composé intermétallique ($Cu_6Sn_5$) à la surface du substrat a une épaisseur de 0,5 $\mu$m, le reste de la couche présentant < 1 % Cu. L'adhérence du revêtement est bonne.

Exemple 9

On dépose du 99,95 % Al sur un substrat de Cu — 4 % Sn préalablement recouvert de 2 $\mu$m de Ni par voie électrolytique, en chauffant ce substrat à 640 °C et le métal de revêtement à 970 °C. La vitesse du substrat est de 2,1 m/min et l'écartement entre la buse et le substrat est de 0,10 mm. La pression exercée sur le métal liquide est de 200 mm de colonne d'eau. Le canal d'alimentation de la buse en graphite a une section rectangulaire de 0,7×5,0 mm.

Le substrat en bande est préalablement dégraissé avec une solution alcaline et soumis à un décapage électrolytique. Le revêtement se déroule sous atmosphère de 10 % $H_2$ — $N_2$ et est ensuite refroidi à l'eau.

Le revêtement ainsi obtenu a une épaisseur de 5,0 $\mu$m maximum et de 4,5 $\mu$m en moyenne, sa dureté est de 54 Vickers et sa rugosité de 0,5 $\mu$m. La couche de composé intermétallique ($NiAl_3$) à la surface du substrat a une épaisseur de 0,5 $\mu$m, le reste de la couche présentant 1,0 % Ni en poids. L'adhérence est bonne.

Exemple 10

On dépose du 99,95 % Al sur un substrat de Cu — 4 % Sn en chauffant ce dernier à 520 °C alors que le métal de revêtement est fondu à 840 °C. La vitesse du substrat est de 4,4 m/min et l'écartement entre la buse et le substrat est de 0,15 mm. La pression exercée sur le métal liquide est de 200 mm de colonne d'eau. Le canal de la buse en graphite a une section rectangulaire de 0,7×5,0 mm.

Le substrat en bande est préalablement dégraissé avec une solution alcaline et décapé par voie électrolytique. Le revêtement se déroule sous atmosphère de $N_2$ — 10 % $H_2$ et est ensuite refroidi à l'eau.

Le revêtement obtenu a une épaisseur maximum de 6 $\mu$m et une épaisseur moyenne de 5 $\mu$m, sa dureté est de 54 Vickers et sa rugosité de 0,05 $\mu$m. On trouve deux couches de composés intermétalliques CuAl et $CuAl_2$ à la surface du substrat qui ont une épaisseur de 1 $\mu$m. Le reste de la couche présente < 3 % en poids de Cu. Le métal du revêtement ne change pas de couleur et son adhérence est bonne.

On constate que le revêtement préalable du substrat par du nickel déposé par voie électrolytique, comme dans l'exemple 9, permet d'augmenter considérablement la pureté du métal de revêtement déposé sur le substrat. Le revêtement selon l'exemple 9 permet de satisfaire l'ensemble des exigences requises pour la fabrication des supports de connexion de circuits intégrés. En effet, l'aluminium du revêtement doit avoir une pureté > 99 % en poids, une épaisseur comprise entre 4 et 10 $\mu$m ± 1 $\mu$m, une largeur comprise entre 2 — 10 mm ± 0,2 mm. La rugosité doit être 0,1 $\mu$m entre creux et bosses. La structure de la couche ne doit pas présenter de défauts, l'épaisseur de la couche intermédiaire doit être < 1 $\mu$m et la dureté < 70 Vickers.

Les revêtements de Pb — 5 % Sn des exemples 5, 6 et 7 satisfont notamment aux exigences requises pour le revêtement des pattes de connexion des supports de circuits intégrés. La dissolution du cuivre du substrat doit être < 1 % en poids et la couche de composé intermétallique doit être < 1 μm. Les dimensions doivent être comprises entre 4-50 μm pour l'épaisseur, 1-30 mm pour la largeur et le profil doit être rectangulaire.

On constate que, malgré le fait de déposer un métal ou alliage en fusion sur un substrat préchauffé, il a été possible de réunir des conditions opératoires qui limitent l'épaisseur de la couche intermétallique entre 0,5 et 5 μm, plus généralement entre 0,5 et 2,5 μm et est généralement inférieure à 25 % de l'épaisseur des couches les plus minces. La dissolution du métal du substrat étant comprise entre 0,5 et 5 % plus généralement entre 0,5 et 2,5 % en poids.

Exemple 11

On dépose du Cu sur un ruban d'acier inoxydable type UNS S31603 (Norme ASTM) en faisant défiler le ruban de 25 mm × 0,25 mm à une vitesse de 4,0 m/mn et en le préchauffant à 670 °C. L'écartement entre le substrat et la sortie de la buse est de 120 μm, la buse a une dimension longueur/largeur de la fente rectangulaire disposée transversalement au sens de défilement du ruban de 20/0,7 mm, la largeur de la lèvre bordant cette fente en aval respectivement en amont par rapport au sens de défilement du ruban est de 1 mm de part et d'autre de cette fente. Le Cu de revêtement est du cuivre électrolytique à 99,95 % et la pression totale à la sortie de la buse est de 300 mm de colonne d'eau. Le ruban d'acier a préalablement été dégraissé avec un produit alcalin et décapé à l'acide. Le dépôt a lieu dans une atmosphère de $N_2$ — 10 % $H_2$ et le refroidissement à la sortie du cylindre de graphyte 14 est réalisé à l'eau.

Le revêtement ainsi obtenu a une épaisseur de 30 μm. La pureté du métal de la bande de revêtement est > 99 %, l'épaisseur de la couche intermétallique est de 0 μm, la dureté est de 80 Vickers et la rugosité de 0,5 μm.

Exemple 12

Même métal déposé sur un même substrat que pour l'exemple 11, le substrat défilant à 2,8 m/mn. Le métal fondu est à 1 340 °C et le substrat à 610 °C. L'écartement entre le substrat et la buse est de 60 μm. La buse a un orifice de sortie rectangulaire disposé transversalement au sens de défilement du substrat de 0,7 × 5 mm. La lèvre 3 disposée en avant de l'orifice 2 à une largeur L' de 2 mm et celle qui est en amont de 1 mm. La pression du métal liquide à la sortie est de 300 mm de colonne d'eau.

Le substrat a été préalablement dégraissé dans une solution alcaline et décapé à l'acide. L'atmosphère du dépôt est composée de $N_2$ — 10 % $H_2$. Le refroidissement à la sortie du cylindre de graphite est réalisé à l'eau.

Le revêtement ainsi obtenu a une épaisseur de 50 μm, une pureté de > 99 % une couche intermétallique de 0 μm, une dureté Vickers de 80 et une rugosité de 0,8 μm.

Exemple 13

On dépose du Cu 5 % Pb sur le même substrat que dans les exemples 11 et 12. La vitesse du substrat est de 3,6 m/mn, la température de l'alliage fondu est de 1 160 °C celle du substrat de 550 °C et l'écartement entre la buse et le substrat est de 60 μm. Les dimensions de la buse sont de 0,7 × 5 mm pour son orifice de sortie transversal au sens de défilement du substrat et des lèvres 3 de 1 mm de largeur de part et d'autre de ces lèvres. La pression à la sortie de la buse est de 100 mm de colonne d'eau.

Les conditions de préparation du substrat, l'atmosphère et le refroidissement restent les mêmes que dans les exemples 11 et 12.

Le revêtement a une épaisseur de 40 μm une pureté > 98 %, une couche intermétallique de 0,5 μm une dureté de 110 Vickers et une rugosité de 0,5 μm.

Exemple 14

On dépose de l'Al 99,95 % sur un substrat de Fe — 42 % Ni défilant à 6,0 m/mn en chauffant l'Al à 740 °C, le substrat à 615 °C et en exerçant une pression à la sortie de la buse de 200 mm de colonne d'eau. L'écartement entre la buse et le substrat est de 250 μm. La buse présente un orifice rectangulaire et transversal au ruban-substrat de 0,7 × 5 mm et des lèvres 3 de 2 mm de part et d'autre de l'orifice 2.

Les conditions de préparation, l'atmosphère et le refroidissement sont les mêmes que dans les exemples 11 à 13.

Le revêtement obtenu a une épaisseur de 30 μm, une pureté > 98 %, une couche intermétallique de 0,4 μm une dureté Vickers de 50 et une rugosité de 0,8 μm.

Exemple 15

On dépose du Pb 3,5 Sn 1,5 % Ag sur un substrat de Ni qui défile à 12,0 m/mn, en chauffant l'alliage au Pb à 490 °C et le substrat à 280 °C. L'écartement entre la buse et le substrat est de 250 μm et la pression à la sortie de la buse de 200 mm de colonne d'eau. La buse a un orifice rectangulaire de 0,7 × 12 mm et une largeur de lèvre en aval de l'orifice de 1 mm et de 2 mm en amont.

Les conditions de dépôt sont les mêmes que pour les Exemples 11 à 14.

Le revêtement obtenu a une épaisseur de 50 μm, une pureté > 99 %, une couche intermétallique de 0,3 μm une dureté Vickers de 80 et une rugosité de 0,7 μm.

Pour résumer, les conditions opératoires essentielles sont la température de préchauffage du substrat qui se situe entre 0,6 et 0,95 du point de fusion du métal de revêtement, la température du métal de revêtement qui se situe entre une et deux fois celle de sa température de fusion, la vitesse de déplacement du substrat qui peut aller de 1 m à 15 m/min, la pression du métal fondu comprise entre 50 et 700 mm de colonne d'eau, la distance fixe entre la buse et le substrat qui peut varier de 50-500 μm, le prolongement L' dans la direction d'avance du substrat qui peut aller de 0,5 à 5 mm, ainsi que la dimension du conduit d'alimentation dans cette direction qui est de 0,3 à 1,2 mm.

## Revendications

1. Procédé pour former sélectivement au moins une bande de revêtement d'un métal ou alliage de 4 à 50 μm d'épaisseur sur un substrat d'un autre métal dont le point de fusion est supérieur à celui du revêtement, en limitant la couche intermétallique à l'interface à une épaisseur maximum de 4 μm dans une limite ne dépassant pas 40 % de l'épaisseur totale, le reste étant formé du métal ou de l'alliage initial utilisé pour le revêtement dans une proportion comprise entre 97 % et 99,5 % en poids, caractérisé par le fait que l'on chauffe ledit substrat à une température correspondant à 0,6-0,95 du point de fusion du métal du revêtement, que l'on fond le métal ou l'alliage de revêtement entre une et deux fois son point de fusion, que l'on amène ce métal ou alliage de revêtement en fusion sur la surface du substrat que l'on déplace à une vitesse de 1-15 m/mn, avec une pression comprise entre 50-700 mm de colonne d'eau à travers un conduit d'alimentation auquel on donne une dimension dans la direction d'avance du substrat comprise entre 0,3-1,2 mm et dont on place la sortie à une distance fixe comprise entre 50-500 μm de la surface du substrat, et que l'on prolonge la face délimitant l'extrémité de sortie du conduit d'alimentation dans la direction d'avance du substrat entre environ 0,5-5 mm, la dimension totale de cette face dans la même direction étant au minimum de l'ordre de 2 mm.

2. Procédé pour former au moins une bande de revêtement sur une face d'un ruban souple selon la revendication 1, caractérisé par le fait que l'on fixe la distance entre l'orifice de sortie du conduit d'alimentation et le substrat en faisant défiler le substrat sur un support.

3. Procédé selon la revendication 2, caractérisé par le fait que l'on refroidit le revers du substrat par conduction avec ledit support dont on dissipe la chaleur cédée par ledit substrat.

4. Procédé selon la revendication 3, caractérisé par le fait que l'on donne à la surface dudit support une forme cylindrique et qu'on l'entraîne en rotation autour de son axe longitudinal à une vitesse périphérique correspondant à celle dudit substrat.

5. Procédé selon la revendication 3, caractérisé par le fait que l'on fait passer ledit substrat dans un fluide de refroidissement lorsqu'il quitte ledit support.

6. Procédé selon la revendication 1, caractérisé par le fait que l'on fixe la distance entre l'orifice de sortie du conduit d'alimentation et le substrat entre 150-200 μm.

7. Procédé selon la revendication 1, caractérisé par le fait que l'on oriente ledit conduit sensiblement verticalement et perpendiculairement audit substrat.

## Claims

1. Method for selectively forming at least one metal or alloy coating strip 4 to 50 μm thick on a substrate of another metal the melting point of which is higher than that of the coating metal, the maximal thickness of the intermetallic layer at the interface being limited to 4 μm and not exceeding 40 % of the total thickness, the remainder consisting of the initial metal or alloy used for the coating in a proportion of between 97 % and 99.5 % by weight, characterized in that the said substrate is heated to a temperature corresponding to 0.6 to 0.95 of the melting point of the coating metal, in that the coating metal or alloy is melted at a temperature of between once and twice that of its melting point, in that this molten coating metal or alloy is deposited onto the substrate surface which is displaced at a speed of 1 to 15 m/min, with a pressure equivalent to a water column of between 50 and 700 mm, via a supply duct which has a dimension of between 0.3 and 1.2 mm in the direction of movement of the substrate and the outlet of which is arranged at a fixed distance of between 50 and 500 μm from the surface of the substrate, and in that the surface difining the outlet end of the supply duct extends in the direction of movement of the substrate by about 0.5 to 5 mm, the total length of this surface in this direction being of the order of at least 2 mm.

2. Method for forming at least one coating strip on one side of a flexible strip according to claim 1, characterized in that the distance between the outlet orifice of the supply duct and the substrate is set by causing the substrate to move on a support.

3. Method according to claim 2, characterized in that the reverse side of the substrate is cooled by means of conduction with the said support which dissipates the heat given off by the said substrate.

4. Method according to claim 3, characterized in that the surface of the said support has a cylindrical shape and in that the said support is driven in rotation about its longitudinal axis at a peripheral speed corresponding to that of the said substrate.

5. Method according to claim 3, characterized in that the said substrate is circulated into a cooling fluid after leaving the said support.

6. Method according to claim 1, characterized in that the distance between the outlet orifice of the supply duct and the substrate is set to between 150 and 200 μm.

7. Method according to claim 1, characterized in that the said duct is oriented substantially vertically and perpendicularly relative to the said substrate.

**Patentansprüche**

1. Verfahren zum selektiven Bilden wenigstens eines Abdeckbandes eines Metalles oder einer Legierung mit 4 bis 50 µm Dicke auf einem Substrat aus einem anderen Metall, dessen Schmelzpunkt höher ist als jener der Abdeckung, wobei die intermetallische Schicht an der Grenzfläche auf eine Dicke von maximal 4 µm mit einer Begrenzung beschränkt wird, die 40 % der Gesamtdicke nicht überschreitet, wobei der Rest aus dem ursprünglichen für die Abdeckung verwendeten Metall oder der ursprünglichen für die Abdeckung verwendeten Legierung in einem Anteil zwischen 97 und 99,5 Gew. % gebildet ist, dadurch gekennzeichnet, daß man das Substrat auf eine Temperatur entsprechend 0,6 bis 0.95 des Schmelzpunktes des Abdeckmetalles erwärmt, daß man das Metall oder die Legierung der Abdeckung zwischen dem ein- und zweifachen Schmelzpunkt schmilzt, daß man dieses geschmolzene Abdeckmetall oder die geschmolzene Abdecklegierung auf die Oberfläche des Substrates bringt, das man mit einer Geschwindigkeit von 1 bis 15 m/mn unter einem Druck zwischen 50 und 700 mm Wassersäule über eine Speiseleitung bewegt, der man eine Abmessung in Bewegungsrichtung des Substrates zwischen 0,3 bis 1,2 mm gibt und deren Austritt man in einem festen Abstand zwischen 50 und 500 µm von der Oberfläche des Substrates anordnet, und daß man die, das Ende des Speiseleitungsaustrittes begrenzende Fläche in Bewegungsrichtung des Substrates zwischen ungefähr 0,5 und 5 mm verlängert, wobei die Gesamtabmessung dieser Fläche in der gleichen Richtung in der Grössenordnung von wenigstens 2 mm liegt.

2. Verfahren zur Bildung wenigstens eines Abdeckbandes auf einer Fläche eines elastischen Bandes gemäß Anspruch 1, dadurch gekennzeichnet, daß man den Abstand zwischen der Öffnung des Speiseleitungsaustrittes und dem Substrat festlegt, indem man das Substrat auf einem Träger vorbeiführt.

3. Verfahren nach Anspruch 2, dadurch gekennzeichnet, daß man die Rückseite des Substrates durch Konduktion mit dem Träger kühlt, mit dem man die durch das Substrat abgegebene Wärme abführt.

4. Verfahren nach Anspruch 3, dadurch gekennzeichnet, daß man der Oberfläche des Trägers eine zylindrische Form gibt und daß man sie in Drehung um ihre Längsachse mit einer Umfangsgeschwindigkeit entsprechend jener des Substrates bewegt.

5. Verfahren nach Anspruch 3, dadurch gekennzeichnet, daß man das Substrat in ein Kühlmedium einbringt, wenn es den Träger verläßt.

6. Verfahren nach Anspruch 1, dadurch gekennzeichnet, daß man den Abstand zwischen der Öffnung des Speiseleitungsaustrittes und dem Substrat zwischen 150 und 200 µm festlegt.

7. Verfahren nach Anspruch 1, dadurch gekennzeichnet, daß man die Leitung im wesentlichen vertikal und senkrecht zum Substrat ausrichtet.

FIG. 1

FIG. 2

FIG. 3

FIG. 4